(19) Europäisches Patentamt
European Patent Office
Office européen des brevets

(11) EP 4 610 392 A1

(12) **EUROPEAN PATENT APPLICATION**

(43) Date of publication:
03.09.2025 Bulletin 2025/36

(21) Application number: 24160777.9

(22) Date of filing: 01.03.2024

(51) International Patent Classification (IPC):
*C23C 14/34* (2006.01)

(52) Cooperative Patent Classification (CPC):
C23C 14/3414; C22C 1/02; C22C 5/06;
C23C 14/185; H01J 37/3426; H01J 37/3429

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
GE KH MA MD TN

(71) Applicant: Materion Advanced Materials Germany
GmbH
63755 Alzenau (DE)

(72) Inventors:
• KONIETZKA, Uwe
  63826 Geiselbach (DE)
• SCHLOTT, Martin
  63075 Offenbach (DE)
• SIMONS, Christoph
  63599 Biebergemünd (DE)

(74) Representative: Kador & Partner Part mbB
Corneliusstraße 15
80469 München (DE)

(54) **AG ALLOY SPUTTERING TARGET WITH HIGH HOMOGENEITY**

(57) The present invention relates to a sputtering target with high homogeneity. The sputtering target is based on silver (Ag) and comprises a low amount of alloying element(s) selected from Mg, Al, Si, Ca, Sr, Sc, Y, rare earth metals, Ti and Ge and combinations thereof. The present invention also relates to a layer produced with said sputtering target and to a process for the production of the sputtering target.

Fig. 2

A

B

500 µm

200 µm

EP 4 610 392 A1

## Description

The present invention relates to a sputtering target with high homogeneity. The sputtering target is based on silver (Ag) and comprises a low amount of alloying element(s) selected from Mg, Al, Si, Ca, Sr, Sc, Y, rare earth metals, Ti and Ge and combinations thereof. The present invention also relates to a layer produced with said sputtering target and to a process for the production of the sputtering target.

Silver-based alloys are known and are often used for producing layers in glazing applications such as for coating architectural glass, or as reflective-layers in optical storage media and displays. Often sputtering targets made of the respective alloy are used for the preparation of layers.

For example, European Patent Application EP 2 647 737 A1 describes sputtering targets of alloys based on silver and at least one further component from indium (In), tin (Sn), antimony (Sb) or bismuth (Bi). These alloys are characterized by high corrosion resistance and are *inter alia* used for the preparation of display layers. Application of AgAl alloys for coating of glass is known. For example, International Application WO 2021/214107 A1 describes AgAl alloys used as metal layers in multilayer solar-control glazing arrangements such as window glass or vehicle glass.

However, there is still a need for further alloys based on silver and respective sputtering targets comprising such alloys. In particular, there is a need for sputtering targets of silver alloys for producing coating layers on glass and display layers. In such applications, it is important to achieve products with good and homogeneous adhesion properties and a uniform layer thickness.

Furthermore, it is generally advantageous to avoid arcing during the sputtering process. Thus, the alloys contained in the sputtering target must be characterized by low susceptibility for this effect.

### *Sputtering target*

The above-discussed aims are achieved by the provision of the sputtering target as defined by the appended claims.

Accordingly, the present invention relates to a sputtering target comprising, or consisting of, an AgX alloy consisting of Ag and from 0.06 to 0.50 at.-% of X, wherein X is at least one alloying element selected from the group consisting of Mg (magnesium), Al (aluminum), Si (silicon), Ca (calcium), Sr (strontium), Sc (scandium), Y (yttrium), rare earth metals, Ti (titanium) and Ge (germanium) and combinations thereof.

Rare earth metals denote herein the elements La (lanthanum), Ce (cerium), Pr (praseodymium), Nd (neodymium), Pm (promethium), Sm (samarium), Eu (europium), Gd (gadolinium), Tb (terbium), Dy (dysprosium), Ho (holmium), Er (erbium), Tm (thulium), Yb (ytterbium) and Lu (lutetium), wherein La (lanthanum) and Ce (cerium) are the preferred alloying elements among the rare earth metals.

It has been surprisingly found that the sputtering targets according to the present invention having a low amount of at least one alloying element X of 0.50 at.-% or less are particularly useful in the application as coatings and layers (e.g., thin films) for glass and displays if the sputtering targets are provided with high homogeneity.

The AgX alloy consists of Ag and X, wherein X is at least one alloying element, selected from the group consisting of Mg, Al, Si, Ca, Sr, Sc, Y, rare earth metals, Ti and Ge and combinations thereof. Preferably, X is at least one alloying element, selected from the group consisting of Mg, Al, Si, Ca, Sr, Sc, Y, La, Ce, Ti, and Ge and combinations thereof, more preferably selected from Al and/or Ti, and most preferably Al.

The selected alloying elements X have good oxygen affinity and thus good adhesion to glass. Accordingly, they form stable layers with good adhesion and corrosion resistance on glass. It is assumed, that the reactive element prevents island growth and hence enables the preparation of a smoother layer even at low film thickness.

The content of X in the AgX alloy is from 0.06 to 0.50 at.-%, preferably from 0.07 to 0.30 at.-% and more preferably from 0.08 to 0.20 at.-%. It is understood that if X comprises more than one alloying element, the content applies to the sum of all alloying elements taken together. It was surprisingly found that such low content of the at least one alloying element X is sufficient to obtain these improved properties.

In one particular embodiment, the AgX alloy consists of Ag and Al, wherein Al is present in an amount of from 0.07 to 0.30 at.-%, more preferably from 0.08 to 0.20 at.-%.

The generally low contents of the alloying element X have the advantage that film conductivity and reflectivity stay high and also that only small amounts of oxides may be contained in the alloy originating from these alloying elements X.

However, preparation of alloys with such low contents of alloying element is generally problematic for at least the following two reasons:

i) Homogeneous distribution of the alloying element in the main metal is difficult to reach. As is apparent, only sputtering targets comprising alloys of homogeneous distribution can lead to homogeneous sputtering of layers, and thus allow for constant properties over the entire size of these layers. Both, in display as well as in architectural glass applications, typical target sizes are in the range of 1.5 up to 4 m in planar or tubular shape.

ii) Reaching the desired amount of doping is quite difficult, in particular for large Ag melts, and such low amounts of additions. Due to the high oxygen affinity of the alloying element X, this element can easily be oxidized during melting and casting and hence becomes transformed to an inactive oxide rather than a dissolved metal.

The present invention provides a sputtering target of an AgX alloy with homogeneous distribution of the at least one alloying element X. The sputtering target is characterized in that the content of X measured at any position of the sputtering target does not deviate by more than 20 %, preferably does not deviate by more than 10 %, such as by 5 % or less, from the average content of X in the sputtering target, the content and average content of X being determined by ICP-OES.

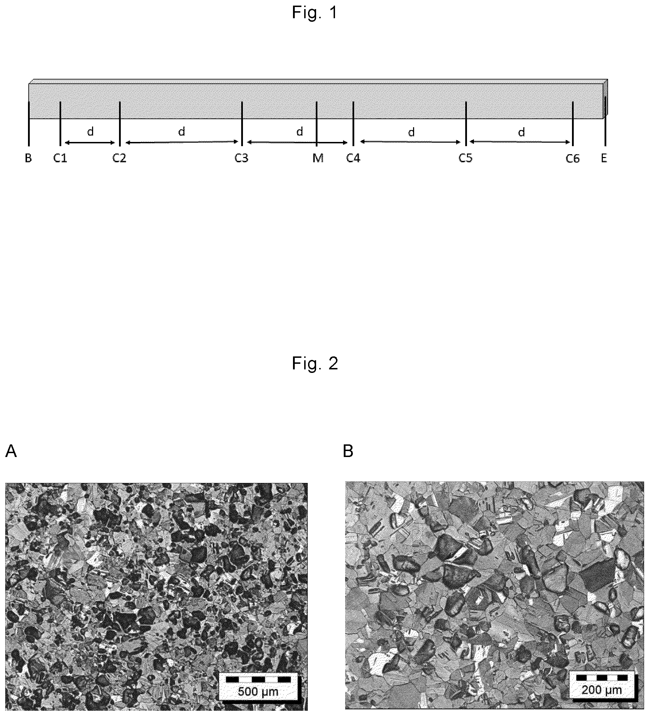

In detail, the average content of X in the sputtering target is determined by ICP-OES as described in detail in the method section. With reference to Fig. 1 depicting a schematic drawing of the target of Example 1, determination of homogeneous distribution is described in the following.

In the sense of the present invention, it is sufficient if six samples are measured at six different positions (C1-C6) on the sputtering target, with the provision that the positions are located along the length, i.e., the long direction of the sputtering target and are selected at least 1/10 of the total sputtering target length apart from each other. In other words, the distance d between the neighboring position is at least 1/10 of the total sputtering target length.

If none of the contents of X at all these six positions deviates by more than 20 % from the average content of X, formed from the contents at these six positions as average:

$$\frac{\sum C1, C2, \ldots C6}{6},$$

it is assumed that a homogeneous distribution is reached.

For calculating the percentage, the atomic percentages (at.-%) of content of X in the AgX alloy are preferably used.

If X comprises more than one alloying element, the above percentage applies to the sum of all alloying elements taken together, i.e., the content of each of the elements is always considered as one part of the sum of the ICP-OES results of added alloying metals, wherein the sum is relevant for the determination of the homogeneous distribution.

It is also preferable that the main part of the at least one alloying element X is incorporated in the AgX alloy in metallic state, i.e., is not present as oxide. This further facilitates solution and homogeneous distribution of the alloying element in the AgX alloy, and uniform adhesion of the prepared layer. Moreover, it has been found that it is advantageous if the alloying element X is in its metallic state in order to improve physical properties of the AgX alloy. Especially micro-arcing events are reduced if the alloying elements are mainly incorporated in their metallic form.

Thus, it is preferable that not more than two, more preferably not more than one and even more preferably no inclusion clusters of the alloying element X in the form of an oxide with a cluster size of more than 1 $\mu m^2$ are detectable in an area of 1 mm$^2$, for a total of five areas at arbitrary positions of a scanning electron microscopy (SEM) sample, and measured as described herein below. A low number of clusters is indicative of a high content of the alloying element being in metallic state. In the analyzed sputtering targets of the present invention no clusters were detectable, meaning that the alloying elements were present in metallic state.

It is further preferable that the AgX alloy has an oxygen content of less than 50 ppm-wt., more preferably less than 20 ppm-wt., even more preferably less than 10 ppm-wt. and most preferably less than 5 ppm-wt. The oxygen content is measured as described herein below and it is indicative of the oxide content of the AgX alloy.

Low contents of oxides are preferable to avoid arcing and micro arcing of the AgX alloy sputtering target. Such electric discharges would otherwise generate splashes that could harm the functionality of the deposited layer. They were not observed in the preparation of layers using the sputtering targets according to the present invention.

In order to achieve a uniform layer thickness, it is also preferred that the AgX alloy has an average grain size of less than 150 $\mu m$, such as in the range of from 10 to less than 150 $\mu m$, preferably from 20 to 120 $\mu m$. In particular, such small grain sizes are favorable for sputtering targets of planar or tubular form having a length of 1 m or more.

It is further preferred that the maximum grain size is less than 300 $\mu m$, for example that the grain sizes range from 5 to less than 300 $\mu m$. Measurement of grain sizes is generally performed according to DIN EN ISO 643 as described herein below.

It is also important that the AgX alloy has a high metallic purity. A minimum metallic purity of 99.9 wt.-% (3N) is required for the AgX alloy. Preferably, the AgX alloy has a metallic purity of at least 99.95 wt.-% (3N5) and more preferably of at least 99.99 wt.-% (4N), based on the Ag matrix. Metallic purity denotes the purity of a metal or an alloy, wherein only elements in the metal or alloy count as impurities, which were not intentionally added. In case of an AgX alloy, X would not be considered an impurity (e.g., Ti would not be considered an impurity in an AgTi alloy).

The layers prepared with the sputtering targets are characterized by uniform thickness and homogeneous distribution of the alloying element X in the AgX alloy, as described above. Further, they are also characterized by excellent adhesion to the substrate (such as glass) due to the presence of the alloying element X in its metallic state having high oxygen affinity, and low contents of oxides in the AgX alloy.

*Process*

The present invention also relates to a process for producing the sputtering target, i.e., a sputtering target comprising an AgX alloy consisting of Ag and from 0.06 to 0.50 at.-% of X, wherein X is at least one alloying element selected from the group consisting of Mg, Al, Si, Ca, Sr, Sc, Y, rare earth metals, Ti and Ge and combinations thereof, and wherein the content of X measured at any position of the sputtering target does not deviate by more than 20 % from the average content of X in the sputtering target, the content and average content of X being determined by ICP-OES as described in the specification, in any of the embodiments and with any of the features described above.

For the production of the sputtering target, it is important that the AgX alloy is provided with homogeneously distributed at least one alloying element X in mainly metallic form, and that the oxide content of the AgX alloy is kept at low level.

It is generally preferred that the Ag metal used is of high metallic purity, such as a metallic purity of at least 99.9 wt.-% (3N), preferably at least 99.95 wt.-% (3N5) and more preferably at least 99.99 wt.-% (4N) or even higher.

It is also preferred that the alloying elements X used are of high metallic purity, such as a metallic purity of at least 99.5 wt.-% (2N5), preferably at least 99.9 wt.-% (3N) and more preferably at least 99.95 wt.-% (3N5) or even higher.

The process according to the present invention comprises preparing the AgX alloy by heating Ag metal pieces (e.g. granules) in an inert container to a temperature range of from 980 to 1200 °C under vacuum or at inert gas conditions in the presence of the at least one alloying element X. In this way, a melt of the AgX alloy is directly prepared. Additional steps such as a dilution of a pre-alloy to the final AgX alloy are not required.

It was surprisingly found that the process according to the present invention, wherein Ag metal is used as the starting material and wherein the alloying element X is directly dispensed into the Ag metal leads to a very homogeneous alloy with very low oxide content. Thus, good distribution of the alloying element X in the Ag matrix is reached, and oxidation of the alloying element X could be minimized.

It is generally known in the art to prepare alloys with such low contents of alloying elements in a 2-step process. Thus, first Ag alloys with higher contents of alloying element (e.g., such as Ag alloys with the 10-fold content of the alloying element) are prepared. These alloys are further "diluted" - in a second step - by adding Ag granules to reach the final Ag alloy with the required small content of the alloying element. However, this 2-step process will increase the oxidation risk for the reactive alloying element. As a consequence, the final composition may be significantly off from the intended one, or a significant amount of the alloying element X may be present as an oxide. This is particularly disadvantageous as the risk of arcing highly increases.

By using the process according to the present invention, these drawbacks can be avoided.

Generally, by the process according to the present invention, a melt is provided, wherein the at least one alloying element X is dispensed into an Ag melt. For this process, preferably, careful degassing of vacuum chamber and crucible is carried out. This is advantageous, in particular, for the addition of the alloying elements X with high oxygen affinity such as Al. The melting process is carried out under vacuum and/or in an inert gas atmosphere (e.g., argon).

The Ag melt is prepared by heating of Ag metal pieces, preferably as Ag granules, in an inert and optionally slightly reducing container (e.g., an alumina or graphite crucible) to a temperature in the range of from 980 to 1200 °C, more preferably from 1000 to 1100 °C. An inert container denotes here a container that resists high temperature of 1200 °C and above without crashing or release of components into the Ag melt under vacuum or inert gas conditions. Inert and optionally slightly reducing containers may e.g., be crucibles made of high purity alumina, graphite, quartz, or the like, or cold hearth crucibles.

In a preferred embodiment, degassed vacuum chamber and crucible for Vacuum Induction Melting, ideally by use of a diffusion pump, are employed.

The melt can then be poured into a mold (e.g., a graphite or steel mold). If the melt is allowed to cool and solidify in this form, a solid shaped body is obtained.

Generally, granules, chips, flakes, platelets and/or wire cut-offs are suitable as Ag metal pieces and pieces of the alloying element X. The alloying element X may also be present in the form of one solid piece, such as a wire.

In some embodiments of the process, the at least one alloying element X is in the form of a solid piece of material of defined dimensions, preferably in the form of a wire of a defined diameter and a defined length, and it is placed at least in part in a volume of the Ag metal pieces, and the Ag metal pieces and the at least one alloying element X are heated to prepare an Ag melt with the at least one alloying element X being dispensed into the Ag melt.

The at least one alloying element X is dispensed into the Ag melt by digestion of the at least one alloying element X from the solid piece of material preferably under stirring the melt. The solid piece of material is at least partially placed in the volume of Ag metal pieces, preferably in a perpendicular position to the open surface of the volume of Ag metal pieces. It may be completely covered by the volume of Ag metal pieces or may range in part outside of this volume and be continuously digested by the prepared Ag melt during the melting process.

The solid piece of material of defined dimensions comprises in particular wires of the alloying element X of a defined diameter and a defined length, such as wires of high melting metals, e.g., Ti wires for the preparation of AgTi alloys.

If more than one alloying element is used, they can be dispensed either concurrently or after each other, preferably concurrently.

In some embodiments of the process, the at least one alloying element X is in the form of pieces, and the Ag metal pieces and the at least one alloying element X are prepared in stacks. First, a stack 1 of Ag metal pieces is provided. A stack 2 of the at least one alloying element X is placed on stack 1. Stack 2 is then covered with a stack 3 of Ag metal pieces (stack 1 and stack 3 make up 100 % of the Ag metal pieces), and the Ag metal pieces and the at least one alloying element X are heated to prepare an Ag melt with the at least one alloying element X being dispensed into the Ag melt.

In these embodiments, preferably, an inert or slightly reducing crucible (e.g., an alumina or graphite crucible) is filled with Ag granules to form stack 1. Pieces of the at least one alloying element X, such as small pieces like chips, platelets, or wire cut-offs of the alloying element X (e.g., Al) are then positioned in the crucible on top of the Ag granules (preferably near the center) to form stack 2, and then are covered with the remaining Ag granules. The Ag melt is formed slowly under heating the crucible to a temperature in the range of from 980 to 1200 °C.

Preferably, stack 1 comprises a higher amount of the Ag metal pieces (e.g., granules) than stack 3, such as 60 to 90 %, preferably 65 to 85 % of the Ag metal pieces used.

In some embodiments of the process, the at least one alloying element X can also be added into the liquid Ag melt via a late charge unit.

For all embodiments of the process, the melt is preferably maintained at the melting temperature for a sufficiently long time to enable a homogeneous distribution of the alloying elements X in the Ag matrix. This dwelling time depends on the total weight of the melt and the agitation during this dwelling time. Typical dwelling times are 10 to 30 minutes. Induction melting is preferred here since it enables intense stirring. Afterwards the melt is cast e.g., into a steel or graphite mold. In this way, a solid block or cylinder of the Ag alloy AgX is produced.

The production process preferably further comprises at least one, more preferably at least two of the steps:

   a) hot working such as rolling, forging and/or extrusion at a temperature in the range of from 400 to 800 °C,
   b) cold working, such as cold rolling, forging or extrusion,
   c) annealing at a temperature in the range of from 300 to 450 °C for a time range of between 30 min and 3 h, depending also on the mass of the plate or tube.

Suitable additional steps of the production process which can be used are described e.g., in EP 3 168 325 A1.

The present invention also relates to a sputtering target in any of the embodiments and with any of the features described above, produced by the process according to the present invention.

### *Applications*

The sputtering target according to the present invention may be used for deposition of Ag alloy layers where high homogeneity and good adhesion of the alloy material and low agglomeration tendency is required or wishful for Ag layers.

For example, the Ag alloys may be deposited as layers on glass or in display products. Preferably such layers are used as reflective layers for visual light or IR radiation. The layers may have a thickness of several nm to about 1000 nm, such as 10 to 20 nm, or 100 to 400 nm.

Accordingly, the present invention also relates to a layer formed by sputtering the AgX alloy from the sputtering target of any of the embodiments described herein, on a substrate.

The layers may be formed by Physical Vapor Deposition (PVD), such as sputtering, ion beam deposition, pulsed laser deposition and combinations thereof, from the Ag alloy of the (planar or tubular) sputtering target. Preferably, the layers are deposited by magnetron sputtering.

The present invention will further be illustrated on the basis of the following examples with reference to the figures, wherein:

Fig. 1:    shows a schematic drawing of an Ag-Al 0.20 at.-% sputtering target of 3750 mm including indicated positions, at which samples for determination of the Al content via ICP-OES were taken; and

Fig. 2:    shows micrographs of samples from a sputtering target of Ag-Al 0.20 at.-%.

### *Measurement methods*

The following methods were used to measure the parameters described herein.

a) Grain size

For the optical determinations by way of SEM and light microscope, the sputtering target samples were obtained by water-jet cutting respective pieces from a target plate or hollow cylinder followed by a first milling step.

The samples were embedded in a resin with the sputter surface up and ground using increasingly finer grain sizes of 120 to 4000 grid and, in the final step, polished with diamond paste. Thereafter, the surface of the samples was etched with hydrogen peroxide/ammonia at 25 °C for 60 s.

The grain sizes were evaluated as follows:

From each micrograph a photo is taken. The magnifications were set in a way that a line drawn over a photograph of the etched samples crosses between 8 and 30 grain boundaries.

Each micrograph was evaluated by the line intersection method (ASTM E112) and the mean grain size was calculated for each of the 10 samples. In addition, the largest grain found by the method is noted for each of the 10 samples.

The average grain size M was determined by the linear intercept method according to DIN EN ISO 643 according to the following equation:

$$M=(L*p)/(N*m)$$

wherein

L: length of the measurement line
p: number of measurement line
N: number of the cut objects
m: magnification

The values were determined at 3*3=9 different measurement locations, each in three depths: 0 mm, 3 mm and 6 mm. Thereafter, the arithmetic mean from the 9 measurement results is found.

b) Determination of homogeneity via Inductively Coupled Plasma (ICP-OES) analysis

Homogeneous distribution of the alloying element(s) X in the AgX alloy is determined by obtaining samples from a sputtering target at six different positions (C1-C6) on the sputtering target, with the provision that the positions are located along the length, i.e., the long direction of the sputtering target and are selected at least 1/10 of the total sputtering target length apart from each other. With reference to Fig. 1, the distance d between two neighboring positions is at least 1/10 of the total sputtering target length. For rectangular sputtering targets, the longest side of the sputtering target is considered the sputtering target length. For cylindrical targets, the distance between the two planar faces of the cylinder is considered the sputtering target length.

The samples are prepared by a press-drill for taking 3 to 10 grams of chips from each location at the target, and the content of X is measured by ICP-OES.

If none of the contents of X at all of these six positions deviates by more than 20 % from the average content of X, it is assumed that homogeneity is present. The average content of X is determined by the following equation:

$$\frac{\sum C1,C2,...C6}{6}.$$

For more than one alloying element in the AgX alloy, the sum of the alloying elements is considered.

For general determination of the average content(s) of the alloying element(s) in any alloy the same ICP-OES method is used.

c) Determination of oxygen content

Chips (about 1 gram) were taken from the sputtering target by a press-drill, etched with nitric acid, carefully dried and measured for oxygen content by the carrier gas method by using a Horiba EMGA-920 system according to standard protocol.

d) Determination of the metallic state of alloying element via SEM

The polished samples from the grain size measurement were taken to an SEM (scanning electron microscope) to investigate them for oxide inclusions. Under high resolution the samples were scanned for oxide clusters. With element maps it was checked whether such clusters were present, which normally was not the case, and whether they were showing also the fingerprint of the alloying element X.

In detail, five arbitrary areas of 1 mm$^2$ on the SEM sample were analyzed for the presence of inclusion clusters of the alloying element X in the form of an oxide with a cluster size of more than 1 $\mu$m$^2$. A low number of clusters is indicative of a high content of the alloying element being in metallic state. A number of not more than two inclusion clusters per area in five areas was considered to represent a high metallic state of the alloying element X.

e) Layer thickness of the layer deposited by sputtering

The layer thicknesses were measured by way of a stylus-type profilometer, such as KLA Tencor D-500. The sample preparation was carried out by partially covering the substrate with Kapton tape, and the correspondingly covered region is not sputtered. After the covering is removed, the layer thickness at the created step between the coated and non-coated regions can be ascertained. The diamond needle of the measuring device measures the layer thickness by way of deflection. The device was calibrated to 1 $\mu$m using the supplied standard. The measurement was repeated in 10 different locations of the sample, and the mean value was found.

**Examples**

Example 1:

*Preparation of AgAl sputtering targets*

Two AgAl sputtering targets with an Al content of 0.08 at.-% and of 0.20 at.-% were produced by vacuum induction melting and casting, followed by hot rolling and annealing to obtain sputtering targets having the dimensions 3750 mm in length and 240 mm in width.

In detail, 370 kg of Ag granules of 4N purity were charged in a graphite crucible together with respectively 7.55 kg or 17.54 kg of small Al pieces of 4N purity. The main portion of the Ag granules was herby placed first in the crucible, then the Al pieces were added around the center on the Ag granules stack. The remaining Ag granules were then placed as a top stack. The arrangement was slowly heated to a pouring temperature of 1040 °C. Melting took place in a conventional vacuum induction furnace in degassed vacuum chamber (base pressure $1\times10^{-3}$ to $2\times10^{-3}$ mbar).

The melt was held for about ½ h for degassing and homogenization and then cast into a cold steel mold to obtain a solid block for subsequent sputtering target production.

Hot rolling was done in multiple passes after preheating the cast ingot to a temperature in the range of 500 to 600 °C for about 2 h. Annealing of the rolled plate was done for about 1 h at a temperature in the range of 300 to 350 °C.

Samples were taken at several positions from the sputtering targets, and prepared and analyzed for homogeneity and their grain properties as described above. Micrographs of samples of the AgAl 0.20 at.-% sputtering target are depicted in Fig. 2.

*Grain properties of the AgAl sputtering targets*

The AgAl sputtering targets were measured for their grain properties according to DIN EN ISO 643 as described above. The results are shown in Table 1 below.

**Table 1:** Grain size properties

| Sample | AgAl 0.08 at.-% | AgAl 0.20 at.-% |
|---|---|---|
| Average grain size | 85 $\mu$m | 71 $\mu$m |
| Maximum gran size | 205 $\mu$m | 179 $\mu$m |
| Minimum grain size | 10 $\mu$m | 6 $\mu$m |

The samples of both sputtering targets achieved fine and homogenous grain size of < 100 $\mu$m of average grain size and <300$\mu$m for the largest grains.

*Homogeneity of the AgAl sputtering targets*

It is referred to Fig. 1, where a schematic drawing of the sputtering target is depicted including the sample positions.

Six samples (C1-C6) were measured at different positions of the AgAl 0.20 at.-% sputtering target as described above having a distance d from each other of at least 1/10 of the target length. Additionally, samples were measured at the beginning (B) and the end (E) of the target, plus one sample was taken from the side at half length, i.e., in the middle of the target length (M). Samples (B), (E) and (M) were not used for determining the average Al content. The contents were measured by ICP-OES, resulting in the values depicted in Table 2 below.

**Table 2:** Al contents in the AgAl 0.20 at.-% sputtering target

| Sample position | C1 | C2 | C3 | C4 | C5 | C6 | B | M | E |
|---|---|---|---|---|---|---|---|---|---|
| Al content (at.-%) | 0.206 | 0.202 | 0.198 | 0.196 | 0.202 | 0.200 | 0.199 | 0.207 | 0.195 |

Based on the samples C1 to C6, the average Al content in the AgAl alloy was calculated to be 0.2007 at.-%. The deviation in the samples was at most 0.0053 at.-% absolute, i.e., 2.7 % for C1.

For the oxygen content of the target a value of 3.5 ppm was determined. No oxide inclusion clusters were detectable. No arcing occurred.

Example 2:

*Preparation of AgTi sputtering targets*

An AgTi sputtering target with a Ti content of 0.19 at.-% was produced by vacuum induction melting and casting, followed by hot rolling to obtain a sputtering target having comparable dimensions to the sputtering target of Example 1.

In detail, Ag granules of 4N purity were charged in a vacuum baked clay-graphite crucible. A Ti wire was placed in the middle of the crucible and being covered to about one half (of the Ti wire) with the Ag granules. The arrangement was slowly heated to a pouring temperature of 1040 °C. Melting took place in a conventional vacuum induction furnace in degassed vacuum chamber (base pressure $1 \times 10^{-3}$ to $2 \times 10^{-3}$ mbar). The uncovered part of the Ti wire was continuously digested by the melt during the formation of liquid Ag.

The melt was held for about ½ h for degassing and homogenization and then cast into a cold steel mold to obtain a solid block for subsequent sputtering target production.

Hot rolling was done in multiple passes after preheating the cast ingot to a temperature in the range of 500 to 600 °C for about 2 h. Annealing of the rolled plate was done for about 1 h at a temperature in the range of 300 to 350 °C.

An AgTi 0.19 at.-% alloy of high homogeneity was obtained in this way, having a deviation in the samples of less than 3 %. For the oxygen content of the target a value of 3.0 ppm was determined. No oxide inclusion clusters were detectable. No arcing occurred.

Example 3:

*Preparation of AgX alloy layers*

Sputtering targets with the dimensions of $488 \times 88 \times 6$ mm$^3$ were prepared from large preforms for full-size targets prepared using the process as described above. They included an AgAl 0.08 at.-% alloy or an AgTi 0.19 at.-% alloy and were used to prepare layers on glass. Coatings comprising one layer of the alloy were deposited by means of magnetron sputtering on $2 \times 2 \times 5$ cm$^3$ glass substrates in an inline coater.

Further parameters of the process were:

Final pressure before process: $1 \times 10^{-6}$ mbar
Process pressure: $3 \times 10^{-3}$ mbar
Ar-flow: 180 sccm
Power density: 1.1 W/cm$^2$
Films coated in dynamic deposition mode

Layers with a thickness of 10 nm, 20 nm and 277 nm were prepared. They were characterized by excellent adhesion properties to the substrate and very smooth and homogeneous appearance. Compared to pure silver targets, no increased micro-arcing was found.

**Claims**

1. A sputtering target comprising an AgX alloy consisting of Ag and from 0.06 to 0.50 at.-% of X, wherein X is at least one alloying element selected from the group consisting of Mg, Al, Si, Ca, Sr, Sc, Y, rare earth metals, Ti and Ge and combinations thereof, and wherein the content of X measured at any position of the sputtering target does not deviate by more than 20 % from the average content of X in the sputtering target, the content and average content of X being determined by ICP-OES as described in the specification.

2. The sputtering target according to claim 1, wherein the at least one alloying element X is Al.

3. The sputtering target according to claim 1, wherein the at least one alloying element X is Ti.

4. The sputtering target according to claim 1, wherein the rare earth metals are La, Ce, Pr, Nd, Pm, Sm, Eu, Gd, Tb, Dy, Ho, Er, Tm, Yb and Lu, preferably La and/or Ce.

5. The sputtering target according to any one of the preceding claims, wherein the AgX alloy consists of Ag and from 0.07 to 0.30 at.-%, preferably from 0.08 to 0.20 at.-%, of the at least one alloying element X.

6. The sputtering target according to any one of the preceding claims, wherein the AgX alloy has an average grain size in the range of from 10 to less than 150 $\mu$m and/or a maximum grain size of less than 300 $\mu$m.

7. The sputtering target according to any one of the preceding claims, wherein the content of X measured at any position of the sputtering target does not deviate by more than 10 % from the average content of X in the sputtering target.

8. The sputtering target according to any one of the preceding claims, wherein the AgX alloy has a metallic purity of at least 99.9 wt.-% (3N), preferably at least 99.95 wt.-% (3N5).

9. The sputtering target according to any one of the preceding claims, wherein the AgX alloy has an oxygen content of less than 50 ppm-wt., preferably less than 20 ppm-wt., more preferably less than 10 ppm-wt. and even more preferably less than 5 ppm-wt.

10. The sputtering target according to any one of the preceding claims, wherein not more than two inclusion clusters of the alloying element X in the form of an oxide with a cluster size of more than 1 $\mu$m$^2$ are detectable in an area of 1 mm$^2$, for a total of five areas at arbitrary positions of a scanning electron microscopy (SEM) sample, and measured as described in the specification.

11. A process for producing the sputtering target according to any one of the preceding claims, comprising preparing the AgX alloy by heating Ag metal pieces in an inert container to a temperature range of from 980 to 1200 °C under vacuum or at inert gas conditions in the presence of the at least one alloying element X.

12. The process according to claim 11, wherein the at least one alloying element X is in the form of a solid piece of material of defined dimensions, preferably in the form of a wire of a defined diameter and a defined length, and it is placed at least in part in a volume of the Ag metal pieces, and the Ag metal pieces and the at least one alloying element X are heated to prepare an Ag melt with the at least one alloying element X being dispensed into the Ag melt.

13. The process according to claim 11, wherein the at least one alloying element X is in the form of pieces, and the Ag metal pieces and the at least one alloying element X are prepared in stacks, with a stack 2 of the at least one alloying element X being placed on a stack 1 of the Ag metal pieces and being covered by a stack 3 of the remaining Ag metal pieces, and the Ag metal pieces and the at least one alloying element X are heated to prepare an Ag melt with the at least one alloying element X being dispensed into the Ag melt.

14. A sputtering target prepared by the process of any one of claims 11 to 13.

15. A layer formed by sputtering the AgX alloy from the sputtering target of any one of claims 1 to 10 or 14 on a substrate.

Fig. 1

Fig. 2

A

B

500 µm

200 µm

Europäisches
Patentamt

European
Patent Office

Office européen
des brevets

# EUROPEAN SEARCH REPORT

Application Number

EP 24 16 0777

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | JP 4 553149 B2 (MITSUBISHI MATERIALS CORP) 29 September 2010 (2010-09-29) | 1,6-8, 11-15 | INV. C23C14/34 |
| Y | * paragraphs [0001], [0015], [0016], [0027]; tables 1, 4 * | 1,6,7,9, 10 | |
| Y | CN 114 395 749 A (LUOYANG GAIN XIN SIFENG ELECTRONIC MAT CO LTD) 26 April 2022 (2022-04-26) * description regarding example 1, third last paragraph of the description; claim 1 * | 1,6,7 | |
| X | JP 2013 191587 A (FUJI ELECTRIC CO LTD) 26 September 2013 (2013-09-26) | 1,2,5 | |
| Y | * paragraphs [0058], [0059]; table 4 * | 1 | |
| Y | CN 114 231 918 A (DONGGUAN TONGGUAN FINE GRINDING POWDER SCIENCE AND TECH LIMITED COMPAN) 25 March 2022 (2022-03-25) * description regarding example 2 * | 6,9,10 | |

TECHNICAL FIELDS
SEARCHED    (IPC)

C23C

~~The present search report has been drawn up for all claims~~

| Place of search | Date of completion of the search | Examiner |
|---|---|---|
| The Hague | 25 September 2024 | Schafranek, Robert |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

& : member of the same patent family, corresponding
    document

EPO FORM 1503 03.82 (P04C01)

Europäisches
Patentamt

European
Patent Office

Office européen
des brevets

## CLAIMS INCURRING FEES

The present European patent application comprised at the time of filing claims for which payment was due.

☐ Only part of the claims have been paid within the prescribed time limit. The present European search report has been drawn up for those claims for which no payment was due and for those claims for which claims fees have been paid, namely claim(s):

☐ No claims fees have been paid within the prescribed time limit. The present European search report has been drawn up for those claims for which no payment was due.

## LACK OF UNITY OF INVENTION

The Search Division considers that the present European patent application does not comply with the requirements of unity of invention and relates to several inventions or groups of inventions, namely:

see sheet B

☐ All further search fees have been paid within the fixed time limit. The present European search report has been drawn up for all claims.

☐ As all searchable claims could be searched without effort justifying an additional fee, the Search Division did not invite payment of any additional fee.

☐ Only part of the further search fees have been paid within the fixed time limit. The present European search report has been drawn up for those parts of the European patent application which relate to the inventions in respect of which search fees have been paid, namely claims:

☒ None of the further search fees have been paid within the fixed time limit. The present European search report has been drawn up for those parts of the European patent application which relate to the invention first mentioned in the claims, namely claims:

2(completely); 1, 5-15(partially)

☐ The present supplementary European search report has been drawn up for those parts of the European patent application which relate to the invention first mentioned in the claims (Rule 164 (1) EPC).

Europäisches
Patentamt
European
Patent Office
Office européen
des brevets

**LACK OF UNITY OF INVENTION
SHEET B**

The Search Division considers that the present European patent application does not comply with the requirements of unity of invention and relates to several inventions or groups of inventions, namely:

```
1. claims: 2(completely); 1, 5-15(partially)

   Subject I regarding regarding the group 2 elements Mg, Ca
   and Sr as well as the group 13 element Al.
                          ---

2. claims: 1, 5-15(all partially)

   Subject II regarding regarding the group 14 elements Si and
   Ge.
                          ---

3. claims: 1, 5-15(all partially)

   Subject III regarding regarding the group 3 elements Sc and
   Y.
                          ---

4. claims: 4(completely); 1, 5-15(partially)

   Subject IV regarding the rare earth elements.
                          ---

5. claims: 3(completely); 1, 5-15(partially)

   Subject V regarding the group 4 element Ti.
                          ---
```

## ANNEX TO THE EUROPEAN SEARCH REPORT
## ON EUROPEAN PATENT APPLICATION NO.

EP 24 16 0777

25-09-2024

| Patent document cited in search report | | Publication date | Patent family member(s) | | Publication date |
|---|---|---|---|---|---|
| JP 4553149 | B2 | 29-09-2010 | JP | 4553149 B2 | 29-09-2010 |
| | | | JP | 2007200519 A | 09-08-2007 |
| | | | TW | 200731253 A | 16-08-2007 |
| CN 114395749 | A | 26-04-2022 | NONE | | |
| JP 2013191587 | A | 26-09-2013 | NONE | | |
| CN 114231918 | A | 25-03-2022 | NONE | | |

EPO FORM P0459

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- EP 2647737 A1
- WO 2021214107 A1
- EP 3168325 A1